(19) **Europäisches Patentamt**

**European Patent Office**

**Office européen des brevets**

(11) **EP 1 591 201 B1**

(12) **EUROPEAN PATENT SPECIFICATION**

(45) Date of publication and mention
of the grant of the patent:
**15.11.2006 Bulletin 2006/46**

(51) Int Cl.:
**B24B 37/04** (2006.01)   **B24D 18/00** (2006.01)

(21) Application number: **05009217.0**

(22) Date of filing: **27.04.2005**

(54) **Chemical mechanical polishing pad, manufacturing process thereof and chemical mechanical polishing method for semiconductor wafers**

Kissen zum chemisch-mechanischen Polieren, Herstellungsverfahren dafür und chemisch-mechanisches Polierverfahren für Halbleiterwafer

Tampon pour le polissage chimico-mécanique, procédé de sa production et méthode de polissage chimico-mécanique pour des plaquettes semiconductrices

(84) Designated Contracting States:
**DE FR IT**

(30) Priority: **28.04.2004 JP 2004132525**

(43) Date of publication of application:
**02.11.2005 Bulletin 2005/44**

(73) Proprietor: **JSR Corporation**
**Tokyo 104-0045 (JP)**

(72) Inventors:
• **Hosaka, Yukio**
**Tokyo 104-0045 (JP)**
• **Shiho, Hiroshi**
**Tokyo 104-0045 (JP)**

• **Miyauchi, Hiroyuki**
**Tokyo 104-0045 (JP)**
• **Okamoto, Takahiro**
**Tokyo 104-0045 (JP)**
• **Hasegawa, Kou**
**Tokyo 104-0045 (JP)**
• **Kawahashi, Nobuo**
**Tokyo 104-0045 (JP)**

(74) Representative: **TBK-Patent**
**Bavariaring 4-6**
**80336 München (DE)**

(56) References cited:
**EP-A- 1 252 973**       **EP-A- 1 466 699**
**WO-A-20/04014603**       **US-A1- 2004 157 533**

**Description**

Field of the Invention

The present invention relates to a chemical mechanical polishing pad, a manufacturing process thereof and a method of polishing a semiconductor wafer.

More specifically, it relates to a chemical mechanical polishing pad capable of transmitting light without reducing its polishing efficiency, a manufacturing process thereof and a method of polishing a semiconductor wafer.

The present invention is used for the polishing of a semiconductor wafer using an optical end-point detector.

Description of the Prior Art

The document EP-A-1 466 699, which constitutes a prior art according to Article 54(3) EPC, discloses a chemical mechanical polishing pad comprising a polishing substrate having a polishing surface and a light-transmitting member fused to the polishing substrate, the selectional form of the light-transmitting member when it is cut with a plane parallel to the polishing surface being elliptic and, further, discloses a manufacturing method of such a pad and a polishing method wherein such a pad is used.

In the polishing of a semiconductor wafer, after the purpose of polishing is accomplished, the polishing end point for terminating polishing can be determined based on a time obtained empirically. However, various materials are used to form the surface to be polished and the polishing time differs by each material. It is conceivable that the material forming the surface to be polished will change in the future. Further, the same can be said of slurry used for polishing and a polishing machine. Therefore, it is extremely inefficient to obtain a polishing time which differs according to the above polishing factors empirically. To cope with this, optical end-point detectors and processes using optical means capable of directly observing the state of the polished surface are now under study (JP-A 9-7985 and JP-A 2000-326220) (the term "JP-A" as used herein means an "unexamined published Japanese patent application").

In the above optical end-point detectors and processes, a window made of a hard and homogenous resin which can transmit end-point detection light and having no essential ability of absorbing and transporting a slurry material is formed in a polishing pad to observe the polished surface only through this window (JP-A 11-512977).

WO-A-2004/014603 discloses a chemical mechanical polishing pad comprising a polishing substrate having a polishing surface and a light-transmitting member provided in the polishing substrate, the light-transmitting member having an oval shape.

However, it is apprehended that the polishing efficiency of the polishing pad is reduced or made non-uniform by forming the window. Therefore, it is difficult to obtain a polishing pad which has a large window or an increased number of windows to ensure the detection of the end point by an optical end-point detector and which is free from the reduction of its polishing efficiency.

Summary of the Invention

It is an object of the present invention to solve the above problem and provide a polishing pad for a semiconductor wafer, capable of transmitting end-point detection light without reducing its polishing efficiency, a manufacturing process thereof, and a method of polishing a semiconductor wafer.

Other objects and advantages of the present invention will become apparent from the following description.

According to the present invention, firstly, the above objects of the present invention are attained by a chemical mechanical polishing pad comprising a polishing substrate having a polishing surface and a light-transmitting member fused to the polishing substrate, the sectional form of the light-transmitting member when it is cut with a plane parallel to the polishing surface being elliptic with a value obtained by dividing its long diameter by its short diameter of 1.5 to 5.

Secondly, the above objects of the present invention are attained by a process for manufacturing the above chemical mechanical polishing pad, comprising fusing the polishing substrate to the light-transmitting member in a metal mold for insert molding.

Thirdly, the above objects of the present invention are attained by a method for the chemical mechanical polishing of a semiconductor wafer with the above chemical mechanical polishing pad, comprising detecting the end point of chemical mechanical polishing with an optical end-point detector through the light-transmitting member of the above chemical mechanical polishing pad of the present invention.

Brief Description of the Drawings

Fig. 1 is a plan view of an example of a light-transmitting member;
Fig. 2 is a plan view of another example of the light-transmitting member;
Fig. 3 is a partial sectional view of an example of the polishing pad of the present invention;
Fig. 4 is a partial sectional view of another example of the polishing pad of the present invention;
Fig. 5 is a plan view of an example of the polishing pad of the present invention;
Fig. 6 is a plan view of another example of the polishing pad of the present invention;
Fig. 7 is a partial sectional view of an example of a metal mold for molding the polishing pad;
Fig. 8 is a partial sectional view of another example of the metal mold for molding the polishing pad
Fig. 9 is a partial sectional view of still another example of the metal mold for molding the polishing pad;
Fig. 10 is a diagram for explaining a polishing method using the polishing pad of the present invention; and
Fig. 11 is a sectional view of an example of a material to be polished.

Detailed Description of the Preferred Embodiments

The present invention will be described in detail hereinunder.

Chemical mechanical polishing pad

The chemical mechanical polishing pad of the present invention has a polishing substrate and a light-transmitting member fused to the polishing substrate. The sectional form of the light-transmitting member when it is cut with a plane parallel to the polishing surface is elliptic with a value obtained by dividing its long diameter by its short diameter (aspect ratio) of 1.5 to 5.

Polishing substrate

The planar shape of the polishing substrate constituting the chemical mechanical polishing pad of the present invention is not particularly limited and may be disk-like, polygonal or square pole-like. The size of the polishing substrate is not particularly limited. However, the shape and size of the polishing substrate are preferably such that it is fitted to the platen of a chemical mechanical polishing machine for use with the chemical mechanical polishing pad of the present invention. The thickness of the polishing substrate is more than 0.1 mm and 100 mm or less, particularly preferably 1 to 10 mm.
The material for forming the polishing substrate is not particularly limited if it can exhibit a function as a polishing pad. It is preferred that pores having the function of holding slurry during polishing and the function of retaining polishing chips temporarily out of the functions of the polishing pad should be formed by the time of polishing. Therefore, it is preferably a material composed of water-soluble particles and a water-insoluble matrix containing the water-soluble particles dispersed therein, or a material composed of cavities and a water-insoluble matrix material containing the cavities dispersed therein, for example, a foam.
In the former material out of these, the water-soluble particles come into contact with an aqueous medium of slurry containing the aqueous medium and a solid at the time of polishing and dissolve or swell to be eliminated, and the slurry can be held in pores formed by elimination. In the latter material, the slurry can be held in pores formed as the cavities.
The material for forming the above water-insoluble matrix is not particularly limited but an organic material is preferably used because it is easily molded to have a predetermined shape and predetermined properties and can provide suitable hardness and suitable elasticity. Examples of the organic material include thermoplastic resins, elastomers, rubbers such as crosslinked rubbers, and curable resins such as thermally or optically curable resins and resins cured by heat or light. They may be used alone or in combination.
Out of these, the above thermoplastic resins include 1,2-polybutadiene resin, polyolefin resins such as polyethylene, polystyrene resins, polyacrylic resins such as (meth)acrylate-based resins, vinyl ester resins (excluding acrylic resins), polyester resins, polyamide resins, fluororesins such as polyvinylidene fluoride, polycarbonate resins and polyacetal resins.
The above elastomers include diene elastomers such as 1,2-polybutadiene, polyolefin elastomer (TPO), styrene-based elastomers such as styrene-butadiene-styrene block copolymer (SBS) and hydrogenated block copolymers thereof (SEBS), thermoplastic elastomers such as thermoplastic polyurethane elastomers (TPU), thermoplastic polyester elastomers (TPEE) and polyamide elastomers (TPAE) silicone resin elastomers and fluororesin elastomers. The rubbers include conjugated diene rubbers such as butadiene rubber (high cis-butadiene rubber, low cis-butadiene rubber, etc.), isoprene rubber, styrene-butadiene rubber and styrene-isoprene rubber, nitrile rubbers such as acrylonitrile-butadiene rubber, acrylic rubber, ethylene-$\alpha$-olefin rubbers such as ethylene-propylene rubber and ethylene-propylene-diene rubber, and other rubbers such as butyl rubber, silicone rubber and fluorine rubber.

The above curable resins include urethane resins, epoxy resins, acrylic resins, unsaturated polyester resins, polyurethane-urea resins, urea resins, silicon resins, phenolic resins and vinyl ester resins.

The above organic materials may be modified by an acid anhydride group, carboxyl group, hydroxyl group, epoxy group or amino group. The affinity for the water-soluble particles to be described hereinafter and slurry of the organic material can be adjusted by modification.

These organic materials may be used alone or in combination of two or more.

Further, the organic material may be a partially or wholly crosslinked polymer or non-crosslinked polymer. It is preferably composed of a crosslinked polymer alone or a mixture of a crosslinked polymer and a non-crosslinked polymer. When a crosslinked polymer is contained, elastic recovery force is provided to the water-insoluble matrix so that displacement caused by shear stress applied to the polishing pad during polishing can be reduced. Further, it is possible to effectively prevent the pores from being filled by the plastic deformation of the water-insoluble matrix when it is excessively stretched at the time of polishing and dressing and the surface of the polishing pad from being excessively fluffed. Therefore, the pores are formed efficiently even during dressing, whereby a reduction in the retainability of the slurry during polishing can be suppressed and further the polishing pad is rarely fluffed, thereby not impairing polishing flatness.

The method of crosslinking the above organic material is not particularly limited. For example, chemical crosslinking making use of an organic peroxide, sulfur or sulfur compound or radiation crosslinking by applying an electron beam may be employed.

Out of the above organic materials, a crosslinked rubber, curable resin, crosslinked thermoplastic resin or crosslinked elastomer may be used as the crosslinked polymer. At least one selected from a crosslinked thermoplastic resin, crosslinked elastomer and polyurethane all of which are stable to a strong acid or strong alkali contained in many kinds of slurry and are rarely softened by water absorption is preferably contained. Out of the crosslinked thermoplastic resin and crosslinked elastomer, what is crosslinked with an organic peroxide is more preferred, and crosslinked 1,2-polybutadiene is particularly preferred.

The content of the crosslinked polymer is not particularly limited but preferably 30 vol% or more, more preferably 50 vol% or more, particularly preferably 70 vol% or more and may be 100 vol% of the water-insoluble matrix. When the content of the crosslinked polymer in the water-insoluble matrix is lower than 30 vol%, the effect obtained by containing the crosslinked polymer may not be fully obtained.

The residual elongation after breakage (to be simply referred to as "residual elongation at break" hereinafter) of the above water-insoluble matrix containing a crosslinked polymer can be 100 % or less when a specimen of the above water-insoluble matrix is broken at 80° C in accordance with JIS K 6251. That is, the total distance between bench marks of the specimen after breakage becomes 2 times or less the distance between the bench marks before breakage. This residual elongation at break is preferably 30 % or less, more preferably 10 % or less, particularly preferably 5 % or less and generally 0 % or more. When the above residual elongation at break is higher than 100 %, fine pieces scraped off from the surface of the polishing pad or stretched at the time of polishing and surface renewal tend to fill the pores disadvantageously. The "residual elongation at break" is an elongation obtained by subtracting the distance between bench marks before the test from the total distance between each bench mark and the broken portion of the broken and divided specimen in a tensile test in which a dumbbell-shaped specimen No. 3 is broken at a tensile rate of 500 mm/min and a test temperature of 80°C in accordance with the "vulcanized rubber tensile test method" specified in JIS K 6251. The test is carried out at 80° C because heat is generated by slide contact at the time of actual polishing.

The above "water-soluble particles" are particles which are eliminated from the water-insoluble material when they come into contact with an aqueous dispersion for chemical mechanical polishing in the polishing pad. This elimination may occur when they dissolve in water contained in this aqueous dispersion upon their contact with water or when they swell and gel by absorbing this water. Further, this dissolution or swelling is caused not only by their contact with water but also by their contact with an aqueous mixed medium containing an alcohol-based solvent such as methanol.

The water-soluble particles have the effect of increasing the indentation hardness of the polishing pad in addition to the effect of forming pores in the polishing pad. For example, the shore D hardness of the polishing pad of the present invention can be set to preferably 35 or more, more preferably 50 to 90, particularly preferably 60 to 85 and generally 100 or less by adding the water-soluble particles. When the shore D hardness is 35 or more, pressure applied to the object to be polished can be increased, and the polishing rate can be thereby improved. In addition, high polishing flatness is obtained. Therefore, the water-soluble particles are particularly preferably made of a solid substance which can ensure sufficiently high indentation hardness for the polishing pad.

The material for forming the water-soluble particles is not particularly limited. They are, for example, organic water-soluble particles or inorganic water-soluble particles. Examples of the material of the organic water-soluble particles include saccharides (polysaccharides such as starch, dextrin and cyclodextrin, lactose, mannitol, etc.), celluloses (such as hydroxypropyl cellulose, methyl cellulose, etc.), protein, polyvinyl alcohol, polyvinyl pyrrolidone, polyacrylic acid, polyethylene oxide, water-soluble photosensitive resins, sulfonated polyisoprene and sulfonated polyisoprene copolymers. Examples of the material of the inorganic water-soluble particles include potassium acetate, potassium nitrate, potassium carbonate, potassium hydrogencarbonate, potassium chloride, potassium bromide, potassium phosphate and magnesium nitrate. These water-soluble particles may be used alone or in combination of two or more. The water-soluble particles may be made of a predetermined single material, or two or more different materials.

The water-soluble particles have an average particle diameter of preferably 0.1 to 500 $\mu$m, more preferably 0.5 to 100 $\mu$m. The pores are as big as preferably 0.1 to 500 $\mu$m, more preferably 0.5 to 100 $\mu$m. When the average particle diameter of the water-soluble particles is smaller than 0.1 $\mu$m, the formed pores become smaller in size than the abrasive grains in use, whereby a polishing pad capable of holding slurry completely may be hardly obtained. When the average particle diameter is larger than 500 $\mu$m, the formed pores become too big, whereby the mechanical strength and polishing rate of the obtained polishing pad may lower.

The content of the water-soluble particles is preferably 1 to 60 vol%, more preferably 1 to 40 vol%, particularly preferably 2 to 30 vol% based on 100 vol% of the total of the water-insoluble material and the water-soluble particles. When the content of the water-soluble particles is set to the above range, a polishing pad having a high polishing rate and excellent hardness and mechanical strength is easily obtained.

It is preferred that the water-soluble particles should dissolve in water only when they are exposed to the surface layer of the polishing pad and should not absorb moisture or swell when they are existent in the interior of the polishing pad. Therefore, the water-soluble particles may have an outer shell for suppressing moisture absorption on at least part of their outermost portion. This outer shell may be physically adsorbed to the water-soluble particle, chemically bonded to the water-soluble particle, or in contact with the water-soluble particle by physical adsorption and chemical bonding. The outer shell is made of epoxy resin, polyimide, polyamide or polysilicate. Even when it is formed on only part of the water-soluble particle, the above effect can be fully obtained.

The water-insoluble matrix material constituting the polishing pad comprising the latter water-insoluble matrix material (foam, etc.) containing cavities dispersed therein is, for example, a polyurethane, melamine resin, polyester, polysulfone or polyvinyl acetate.

The average size of the cavities dispersed in the water-insoluble matrix material is preferably 0.1 to 500 $\mu$m, more preferably 0.5 to 100 $\mu$m.

The method of dispersing the above water-soluble particles into the matrix material at the time of production is not particularly limited. For instance, the matrix material and water-soluble particles and optionally other additives are kneaded together to obtain a dispersion. The shape of the obtained dispersion is not particularly limited. For example, it is obtained in the form of a pellet, crumb or powder. The matrix material is preferably kneaded under heating so that it can be easily processed. At this heating temperature, the water-soluble particles are preferably solid.

When they are solid, the water-soluble particles are easily dispersed while they show the above preferred average particle diameter. Therefore, the types of the water-soluble particles are preferably selected according to the processing temperature of the used matrix material.

Light-transmitting member

The light-transmitting member is a member for forming a portion having light transmission properties in part of the polishing pad so that it forms a common surface together with the polishing surface of the polishing substrate.

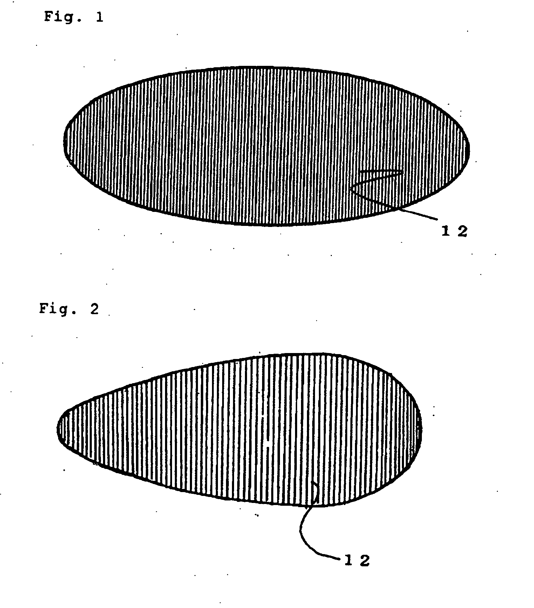

The sectional form of this light-transmitting member when it is cut with a plane parallel to the polishing surface is elliptic with a value obtained by dividing its long diameter by its short diameter (aspect ratio) of 1.5 to 5. The term "elliptic" as used herein comprehends a concept including, for example, a mathematically elliptic shape as shown in Fig. 1 and a deformed roughly elliptic shape like a hen's egg as shown in Fig. 2. When the sectional form of the chemical mechanical polishing pad is circular, the long diameter direction of the light-transmitting member is preferably parallel to the diameter direction of the polishing surface.

This light-transmitting member and the above polishing substrate are fused together into a single body.

The term "fusion" refers to a state in which the light-transmitting member and the polishing substrate are bonded together by melting or dissolving at least the bonding surface(s) of both or one of them without using an adhesive. For the manufacture of the polishing pad, not only the bonding surface but also the entire light-transmitting member may be molten to be bonded, or the entire polishing substrate may be molten to be bonded.

The method of fusing together the light-transmitting member and the polishing substrate is not particularly limited. For instance, it may be (1) an insert molding method in which one of the light-transmitting member and the polishing substrate is held in a metal mold and the other member is injected and fused, (2) a method in which the light-transmitting member and the polishing substrate are manufactured in predetermined shapes and mated together, and their contact surfaces are molten to be bonded together by infrared welding, high-frequency welding, microwave welding or ultrasonic welding, or (3) a method in which a solvent is applied to the bonding surfaces of the light-transmitting member and the polishing substrate to bond them together.

Since the light-transmitting member and the polishing substrate of the polishing pad of the present invention are fused together, there is no gap between the light-transmitting member and the polishing substrate, whereby slurry does not leak to the rear side of the polishing pad.

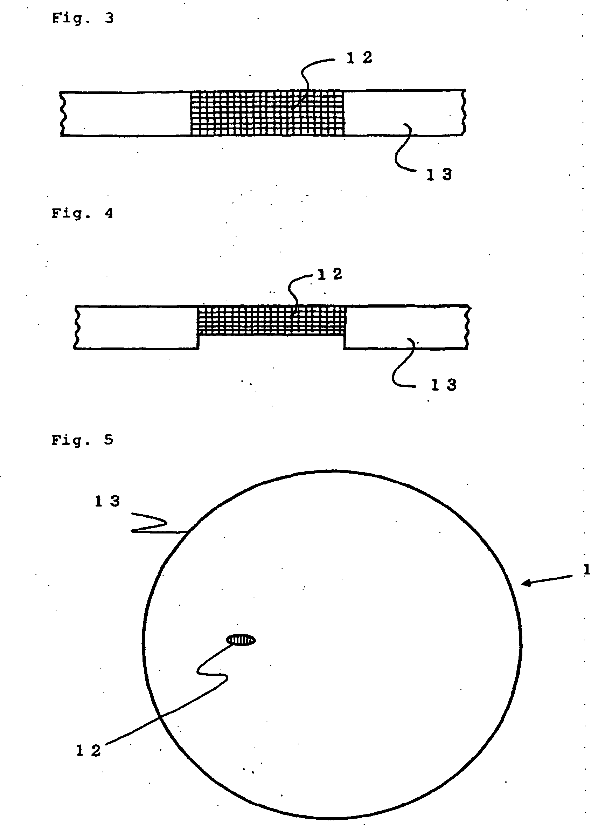

Fig. 3 and Fig. 4 are partial sectional views of the polishing pad of the.present invention when it is cut with a plane perpendicular to the polishing surface and passing through the light-transmitting member. The above light-transmitting member 12 may be the same in thickness as the polishing substrate 13 as shown in Fig. 3 or thinner than the polishing substrate 13 as shown in Fig. 4.

The number of the above light-transmitting members is not particularly limited and may be one or more. The position(s) of the light-transmitting member(s) is/are not particularly limited. However, the light-transmitting member(s) should be arranged on the polishing pad such that it/they is/are located in a portion(s) through which the end-point detection light of a chemical mechanical polishing machine for use with the chemical mechanical polishing pad of the present invention passes.

The percentage of the area of the light-transmitting member(s) to the total area of the polishing surface is preferably 10 % or less, more preferably 0.005 to 10 %, much more preferably 0.005 to 5 %, particularly preferably 0.01 to 1 %. By setting the percentage to this range, end-point detection can be ensured and high polishing efficiency can be obtained.

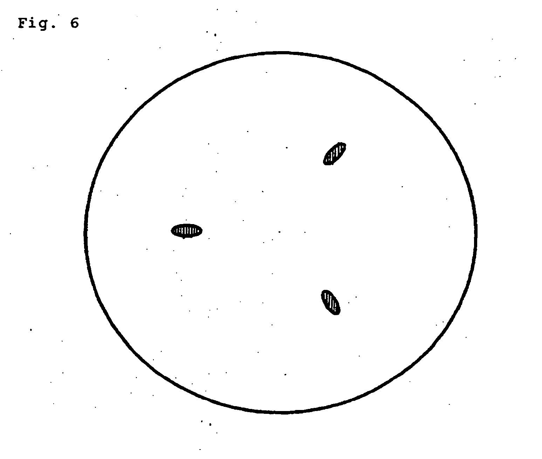

Fig. 5 and Fig. 6 show examples of the position(s) of the light-transmitting member(s) of the polishing pad of the present invention on the polishing surface.

As for the light transmission properties of the light-transmitting member, when the thickness of the light-transmitting member is 2 mm, it preferably has a transmittance at a wavelength between 100 and 3,000 nm of 0.1 % or more or an integrated transmittance at a wavelength between 100 and 3,000 nm of 0.1 % or more. This transmittance or integrated transmittance is more preferably 1 % or more, much more preferably 2 % or more, particularly preferably 3 % or more, ideally 4 % or more. The transmittance or integrated transmittance does not need to be higher than required, and may be 50 % or less, preferably 30 % or less, particularly preferably 20 % or less.

In the polishing pad used for polishing using an optical end-point detector, the light-transmitting member preferably has a high transmittance at a wavelength range of 400 to 800 nm which is frequently used as light for end-point detection. Therefore, the transmittance at a wavelength of 400 to 800 nm preferably satisfies the above requirement.

This transmittance is a value measured at a wavelength with an UV absorptiometer which can measure the absorbance of a 2 mm-thick specimen at a predetermined wavelength. The integrated transmittance can be obtained by integrating transmittances at a predetermined wavelength range measured similarly.

The above light-transmitting member is composed of a water-insoluble matrix material and optionally added water-soluble particles. When water-soluble particles are added, they are preferably dispersed into the water-insoluble matrix.

The water-insoluble matrix material (may be simply referred to as "matrix material" hereinafter) constituting the above light-transmitting member is preferably a thermoplastic resin, thermosetting resin, elastomer, rubber or a combination thereof which can provide light transmission properties. Although this matrix material does not need to be transparent or semitransparent if it has light transmission properties (which does not mean that it transmits only visible light), it preferably has higher light transmission properties, more preferably transparency.

The thermoplastic resin, thermosetting resin, elastomer, rubber, etc. which can provide light transmission properties may be the same as those listed for the water-insoluble matrix material used in the above polishing substrate. These matrix materials may be used in combination of two or more. Further, the water-insoluble matrix material may be a mixture of a polymer having a functional group and a polymer having no functional group as explained in detail for the above polishing substrate.

The matrix material may be a crosslinked polymer or non-crosslinked polymer. At least part of the matrix material is preferably a crosslinked polymer. For example, the matrix material is a mixture of two or more materials and at least part of at least one of the materials is a crosslinked polymer, or the matrix material is only one material and at least part of the material is a crosslinked polymer.

When at least part of the matrix material has a crosslinked structure, elastic recovery force can be provided to the matrix material. Therefore, it is possible to suppress displacement caused by shearing stress applied to the polishing pad at the time of polishing and to prevent the pores from being filled by the plastic deformation of the matrix material when it is excessively stretched at the time of polishing and dressing. It is also possible to prevent the surface of the polishing pad from being fluffed excessively. Conseqqently, the retainability of slurry at the time of polishing is high, the retainability of slurry is easily recovered by dressing, and further scratching can be prevented.

These crosslinked polymers are the same as those which have been already described in detail for the above polishing substrate.

Out of these crosslinked polymers, crosslinked 1,2-polybutadiene and polyurethane are particularly preferred because they can provide sufficiently high light transmission properties, are stable to a strong acid or strong alkali contained in many kinds of slurry and further are rarely softened by water absorption. This crosslinked 1,2-polybutadiene may be blended with other rubber such as butadiene rubber or isoprene rubber. Further, 1,2-polybutadiene may be used alone as the matrix material.

The residual elongation after breakage (to be simply referred to as "residual elongation at break" hereinafter) of the matrix material at least part of which is a crosslinked polymer can be set to 100 % or less when a matrix material specimen is broken at 80°C in accordance with JIS K 6251. That is, it is a matrix material having a total distance between bench marks of the specimen after breakage which is 2 times or less the distance between the bench marks before breakage. This residual elongation at break is preferably 30 % or less, more preferably 10 % or less, and particularly preferably 5% or less. As the residual elongation at break becomes higher than 100 %, fine pieces scraped off from the surface of the polishing pad or stretched at the time of polishing or surface renewal tend to fill the pores.

The "residual elongation at break" is an elongation obtained by subtracting the distance between bench marks before the test from the total distance between each bench mark and the broken portion of the broken and divided specimen in a tensile test in which a dumbbell-shaped specimen No. 3 is broken at a tensile rate of 500 mm/min and a test temperature of 80° C in accordance with the "vulcanized rubber tensile test method" specified in JIS K 6251. The test temperature is 80°C as the temperature reached by slide contact at the time of actual polishing is about 80°C.

The above water-soluble particles are dispersed in the light-transmitting member. They are made of a substance capable of forming pores by its contact with an aqueous medium supplied from the outside at the time of polishing as described above.

The shape, size, content in the light-transmitting member and material of the water-soluble particles are the same as those of the water-soluble particles which have been described in detail for the above polishing substrate.

It is preferred that the water-soluble particles should dissolve in water or swell only when they are exposed to the surface of the light-transmitting member and should not absorb moisture or swell when they are existent in the interior of the light-transmitting member without surfacing. Therefore, an outer shell made of an epoxy resin, polyimide, polyamide or polysilicate for suppressing moisture absorption may be formed on at least part of the outer surface of the water-soluble particle.

The water-soluble particles have the function of matching the indentation hardness of the light-transmitting member with that of other portion of the polishing pad in addition to the function of forming pores. The Shore D hardness of the entire polishing pad is preferably set to 35 to 100 in order to increase pressure to be applied at the time of polishing, improve polishing rate and obtain high flatness. However, it is often difficult to obtain a desired Shore D hardness only from the matrix material. In this case, the shore D hardness can be increased to the same level as that of other portion of the polishing pad by containing the water-soluble particles, besides the purpose of forming pores. For this reason, the water-soluble particles are preferably made of a solid material capable of securing sufficiently high indentation hardness in the polishing pad.

The method of dispersing the water-soluble particles in the matrix material at the time of production may be the same as the method which has been described for the above polishing substrate.

The polishing pad of the present invention may have a fixing layer for fixing the polishing pad on a polishing machine on the rear surface opposite to the polishing surface at the time of polishing. The fixing layer is not particularly limited if it can fix the polishing pad itself.

This fixing layer may be a layer formed by using an adhesive double-coated tape, for example, a layer comprising an adhesive layer and a peel layer formed on the outer surface of the adhesive layer, or an adhesive layer formed by applying an adhesive. The peel layer may be formed on the outer surface of the adhesive layer formed by applying an adhesive.

The adhesive material for forming the fixing layer is not particularly limited. It is, for example, a thermoplastic, thermosetting or optically curable acrylic adhesive or synthetic rubber adhesive. Commercially available products of the adhesive material include #442 of 3M Limited and #5511 and #5516 of Sekisui Chemical Co., Ltd.

Out of these fixing layers, a layer formed by using an adhesive double-coated tape is preferred because it has a peel layer in advance. A fixing layer having a peel layer can protect an adhesive layer before use and can easily fix the polishing pad on the polishing machine by removing the peel layer at the time of use.

The light transmission properties of the material of the fixing layer are not particularly limited. When the material of the fixing layer does not have light transmission properties or has low light transmission properties, a through hole may be formed at a position corresponding to the light-transmitting member. This through hole may be larger or smaller than or the same as the area of the light-transmitting member.

The fixing layer may not be formed in the path of transmitted light when a through hole is formed in the fixing layer.

Further, when a fixing layer is formed by using an adhesive double-coated tape, a through hole can be formed at a predetermined position of the adhesive double-coated tape. The method of forming this through hole is not particularly limited. The through hole may be formed with a laser cutter or punching blade. When a laser cutter is used, the through hole may be formed after a fixing layer is formed by using an adhesive double-coated tape.

Process for manufacturing a chemical mechanical polishing pad

Although the process for manufacturing the polishing pad of the present invention is not particularly limited, the polishing pad of the present invention is preferably manufactured by using mainly the following metal mold for insert molding.

Metal mold for insert molding

The metal mold for insert molding used in the process for manufacturing the polishing pad of the present invention has a projection portion(s) and/or a depressed portion (a) for positioning the light-transmitting member or the polishing substrate, which has been molded in advance.

The position, shape, size and number of the projection portions and/or depressed portions for positioning the light-transmitting member or the polishing substrate are not particularly limited if they can position the light-transmitting member or the polishing substrate.

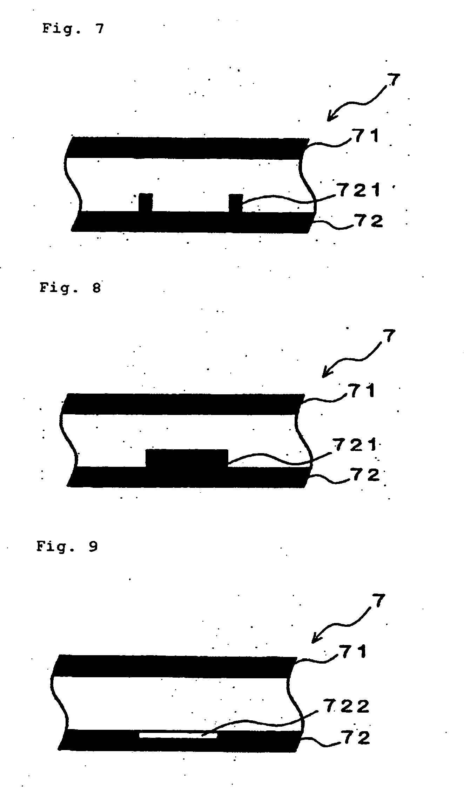

As for the projection portion(s) for positioning the light-transmitting member, (1) a plurality of, for example, 3 or 4 dot-like, point-like or prolonged projections 721 are arranged on a lower mold 72 to surround the light-transmitting member as shown in Fig. 7, (2) the above projection is arranged such that it is mated with a depression formed in the center of the bottom of the light-transmitting member, or (3) a ring projection, partially ring projection or quadrilateral projection, for example, rectangular projection is arranged such that it is mated with the light-transmitting member having a circular bottom or quadrilateral bottom to surround the light-transmitting member so as to form a ring or square as a whole. Reference numeral 71 denotes an upper mold.

As for the projection portion(s) for positioning the polishing substrate, as shown in Fig. 8, a disk-like or thin square pole-like projection 721 is formed on the lower mold 72 to be mated with a hole for mounting the light-transmitting member of the polishing substrate, or a dot-like, point-like or prolonged projection is formed on the lower mold 72 to be mated with a depression formed in the polishing substrate. .

Since the surface of the projection portion for fixing this polishing substrate is the surface for forming the surface layer of the light-transmitting member, the surface of the projection portion desirably has excellent flatness to improve the light transmission properties of the light-transmitting member. It is desirably planished.

As for the depressed portion(s) for positioning the light-transmitting member, as shown in Fig. 9, a circular or quadrilateral depression 722 is formed in the lower mold 72 to be mated with the light-transmitting member, or depressions are formed in the lower mold 72 to be mated with a plurality of dot-like, point-like or prolonged projections formed on the light-transmitting member.

Further, as for the depressed portion(s) for positioning the polishing substrate, depressions may be arranged to be mated with dot-like, point-like or prolonged projections formed on the bottom portion of the polishing substrate.

Process for manufacturing a polishing pad

The process for manufacturing the polishing pad of the present invention is not particularly limited if the light-transmitting member or the polishing substrate can be held in the metal mold and the material for forming the light-transmitting member or the polishing substrate can be injected into the cavity. To facilitate the manufacture of the polishing pad of the present invention, the above metal mold for insert molding is preferably used.

This manufacturing process is preferably the following process (1) or (2).

(1) A dispersion is obtained by pre-kneading a matrix, a water-soluble substance, etc. for forming the light-transmitting member. The obtained dispersion is molded in a metal mold having a molding cavity to manufacture the light-transmitting member.

Then, this light-transmitting member is set in a metal mold having a cavity and a dispersion for forming the polishing substrate, obtained by kneading or the like, is injected into the metal mold and molded to obtain a polishing pad.

Stated more specifically, the pre-molded light-transmitting member is held between the projection portions of the metal mold for insert molding having projection portions (see Fig. 7) for positioning. Thereafter, the metal mold 71 is clamped and the dispersion for forming the polishing substrate, obtained by kneading or the like, is injected from an injection port into the remaining space in the mold. This dispersion is solidified by cooling to mold a polishing pad. Before the above metal mold is closed, the dispersion for forming the polishing substrate may be directly injected, and then the above metal mold may be clamped for molding.

(2) A polishing substrate having a hole for accepting the light-transmitting member is first molded and then set in a metal mold having a cavity, a dispersion for forming the light-transmitting member, obtained by kneading or the like, is injected into the hole of the polishing substrate and molded in the metal mold to manufacture the light - transmitting member, thereby obtaining a polishing pad. The above hole may be a hole with a bottom or a through hole without a bottom. A polishing substrate having a through hole is preferably used.

Stated more specifically, a polishing substrate molded in a predetermined shape is held onto the projection portion of a metal mold for insert molding having the projection portion (see Fig. 8) for positioning. Thereafter, the metal mold is clamped and the dispersion for forming the light-transmitting member, obtained by kneading or the like, is injected from an injection port to be molded. Before the above metal mold is closed, the dispersion for forming the light-transmitting member may be directly injected and the above metal mold may be clamped for molding.

In the above processes (1) and (2), the inside temperature of the metal mold for insert molding is preferably 30 to 300°C. more preferably 40 to 250°C, much more preferably 50 to 200°C.

The height of the light-transmitting member and the thickness of the polishing substrate do not need to be the same basically. Further, the flatness of the polished surface may be improved and the polishing pad may be processed to a desired thickness by grinding with sandpaper after molding.

A groove or dot pattern may be formed in a predetermined shape on the polishing surface of the polishing pad of the present invention as required in order to improve the dischargeability of the used slurry. When the groove or dot pattern is required, it can be obtained by forming a depression on the front side of the polishing pad by reducing the thickness of the above light-transmitting member. Polishing laminated pad

The polishing pad of the present invention can be provided as a polishing laminate having a base layer formed on the rear surface.

The above "base layer" is a layer formed on the rear surface opposite to the polishing surface of the polishing pad. It doesn't matter whether the base layer has light transmission properties or not. When a base layer made of a material having the same or higher light transmission properties than the light-transmitting member is used, light transmission properties are ensured for the polishing laminated pad. In this case, a through hole may be or may not be formed at a position corresponding to the light-transmitting member of the base layer.

When a base layer having no light transmission properties is used, the light transmission properties of the polishing laminated pad can be secured by forming a through hole at a position corresponding to the light-transmitting member.

The shape of the base layer is not particularly limited and its planar shape may be quadrate, for example, quadrilateral, or circular. Further, it can be formed as a sheet. This base layer preferably has the same planar shape as the polishing pad. The material for forming the base layer is not particularly limited and various materials may be used. An organic material is preferably used because it is easily molded to have a predetermined shape and predetermined properties and can be provided with suitable elasticity. The same materials as those used as the matrix material of the above-described light-transmitting member may be used as this organic material. The material for forming the base layer may be the same or different from the matrix material(s) of the light-transmitting member and/or the polishing substrate.

The number of the base layers is not particularly limited and may be one or more. When two or more base layers are formed, they may be the same or different. The hardness of the base layer is npt particularly limited but preferably lower than that of the polishing pad. Thereby, the polishing laminated pad has sufficiently high flexibility and suitable conformability to the unevenness of the surface to be polished as a whole.

When the polishing pad of the present invention is a polishing laminated pad, a fixing layer may be formed like the above polishing pad. The fixing layer in the laminated pad is preferably formed on the rear surface of the base layer, that is, the surface opposite to the polishing surface. The fixing layer is the same as that which has been explained for the above polishing pad.

Method of polishing a semiconductor wafer

The method of polishing a semiconductor wafer of the present invention is to polish a semiconductor wafer with the polishing pad of the present invention, using an optical end-point detector for detecting the polishing end point of the semiconductor wafer.

The above optical end-point detector is capable of detecting the polishing end point of the surface to be polished from light reflected from the surface of an object to be polished by letting light pass through the light-transmitting member to the polishing surface side from the rear surface side of the polishing pad. Other measurement principles are not particularly limited.

In the method of polishing a semiconductor wafer of the present invention, the detection of the end point can be carried out without reducing polishing efficiency. For example, when the polishing pad or the polishing laminated pad is disk-like, the light-transmitting members are arranged in a loop concentric to the center of the disk so that polishing can be carried out while the polishing end point is always monitored. Therefore, polishing can be ended surely at the optimal polishing end point.

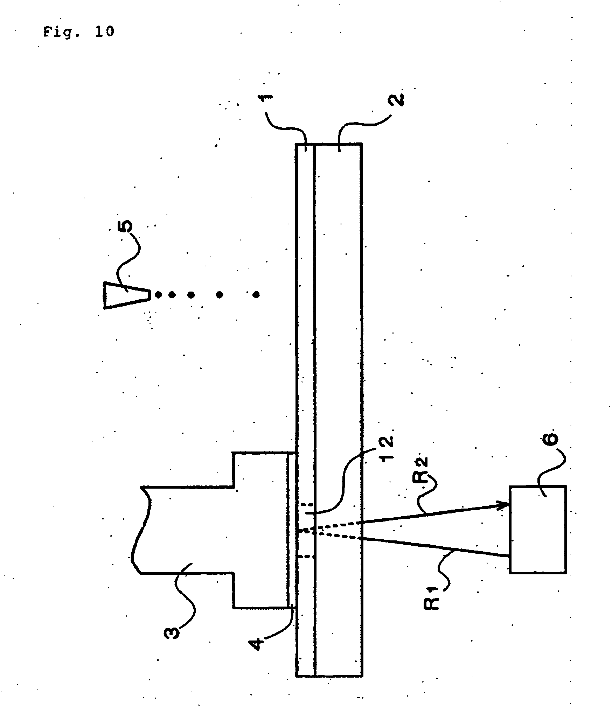

In the method of polishing a semiconductor wafer of the present invention, a polishing machine shown in Fig. 10 may be used. That is, the machine comprises a rotatable platen 2, a pressure head 3 which can turn and move in vertical and horizontal directions, a slurry feed unit 5 which can drop a predetermined amount per unit time of slurry on the platen 2, and an optical end-point detection unit 6 installed below the platen 2.

In this polishing machine, the polishing pad (including the polishing laminated pad) 1 of the present invention is fixed on the platen 2, and the semiconductor wafer 4 is fixed to the under surface of the pressure head 3 and pressed against the polishing pad at a predetermined pressure. Slurry is dropped on the platen 2 from the slurry feed unit 5 in a predetermined amount each time, and the platen 2 and the pressure head 3 are turned to bring the semiconductor wafer in slide contact with the polishing pad for polishing.

End-point detection radiation $R_1$ having a predetermined wavelength or wavelength range is applied from the optical end-point detection unit 6 to the polished surface of the semiconductor wafer 4 from below the platen through the light-transmitting member 12 for polishing. That is, the platen itself has light transmission properties or a cut-out portion so that the end-point detection radiation can pass therethrough. Reflected radiation $R_2$ obtained by reflecting this end-point detection radiation $R_1$ from the polished surface of the semiconductor wafer 4 is seized by the optical end-point detection unit 6 so that polishing can be carried out while the state of the polished surface is monitored from this reflected radiation.

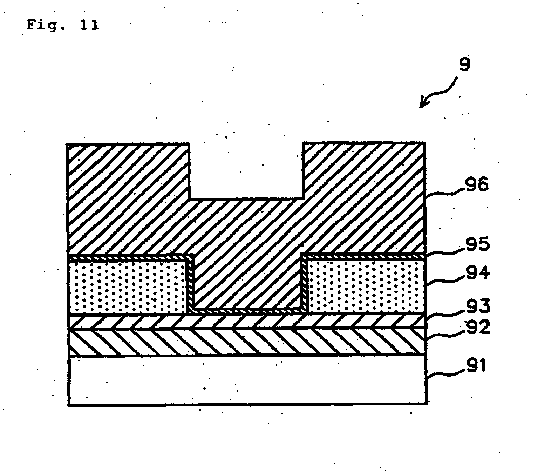

The suitable material to be polished by the polishing method of the present invention is, for example, a laminated substrate having a structure shown in Fig. 11. This laminated substrate comprises a substrate made of silicon or the like, a first insulating film made of silicon oxide or the like, a second insulating film having a groove (such as a TEOS-based oxide film, for example, a silicon oxide-based insulating film formed from tetraethoxysilane by chemical vapor deposition, insulating film having a low dielectric constant (such as silsequioxane, fluorine-added $SiO_2$, polyimide-based resin, benzocyclobutene, etc.), etc.), a barrier metal film and a metal film as a wiring material (pure copper film, pure tungsten film, pure aluminum film, alloy film, etc.) formed in the mentioned order.

The object to be polished is, for example, an object to be polished including a buried material, or an object to be polished including no buried material.

The object to be polished including a buried material is, for example, a laminate which comprises a desired material deposited by CVD or the like so that the desired material is buried at least in the groove of a substrate which will become a semiconductor device (which generally comprises at least a wafer and an insulating film formed on the front surface of the wafer. It may further comprise a stopper layer as a stopper at the time of polishing formed on the front surface of the insulating film) having a groove at least on the front surface. For the polishing of this object to be polished, after the buried material deposited excessively is removed by polishing with the polishing pad of the present invention, the front surface thereof can be polished to be flattened. When the object to be polished has a stopper layer under the buried material, the stopper layer may be polished in the latter stage of polishing at the same time.

The buried material is, for example, (1) an insulating material used in the STI step, (2) at least one metal wiring material selected from Al and Cu used in the damascene process, (3) at least one via plug material selected from Al. Cu and W used in the step of forming a via plug, or (4) an insulating material used in the step of forming an interlayer insulating film.

The stopper material for forming the above stopper layer is a nitride-based material such as $Si_3N_4$, TaN or TiN, or a metal-based material such as tantalum, titanium or tungsten.

Examples of the above insulating material include a silicon oxide ($SiO_2$) film, boron phosphorus silicate film (BPSG film) obtained by adding small amounts of boron and phosphorus to $SiO_2$, insulating film called "FSG (Fluorine doped silicate glass)" obtained by doping $SiO_2$ with fluorine, and silicon oxide-based insulating film having a low dielectric constant.

Examples of the silicon oxide film include a thermal oxide film, PETEOS film (Plasma Enhanced-TEOS film), HDP film (High Density Plasma Enhanced-TEOS film) and silicon oxide film obtained by thermal CVD.

The above thermal oxide film can be formed by exposing silicon heated at high temperature to an oxidative atmosphere to cause a chemical reaction between silicon and oxygen or between silicon and water.

The above PETEOS film can be formed by the chemical vapor deposition of tetraethyl orthosilicate (TEOS) using plasma as a promoting condition.

The above HDP film can be formed by the chemical vapor deposition of tetraethyl orthosilicate (TEOS) using high-density plasma as a promoting condition.

The above silicon oxide film obtained by thermal CVD can be obtained by atmospheric CVD (AP-CVD) or low-pressure CVD (LP-CVD).

The above boron phosphorus silicate film (BPSG film) can be obtained by atmospheric CVD (AP-CVD) or low-pressure CVD (LP-CVD).

The above insulating film called "FSG" can be formed by chemical vapor deposition using high-density plasma as a promoting condition.

Further, the above silicon oxide-based insulating film having a low dielectric constant can be obtained by applying a raw material to a substrate by rotational coating and heating it in an oxidative atmosphere, as exemplified by an HSQ film (Hydrogen Silsesquioxane film) obtained from triethoxysilane, and MSQ film (Methyl Silsesquioxane film) obtained from tetraethoxysilane and methyl trimethoxysilane as a part of raw material.

Other insulating films having a low dielectric constant include films obtained from an organic polymer such as polyarylene-based polymer, polyarylene ether-based polymer, polyimide-based polymer or benzocyclobutene polymer.

This flush type laminate is shown in Fig. 11. That is, the laminated substrate 9 comprises a substrate 91 made of silicon or the like, an insulating film 92 made of silicon oxide or the like formed on the silicon substrate 91, an insulating film 93 made of silicon nitride or the like formed on the insulating film 92, an insulating film 94 made of PTEOS (material synthesized from tetraethoxysilane by CVD) formed on the insulating film 93 to form a groove, a barrier metal film 95 made of tantalum or the like formed to cover the insulating film 94 and the groove, and a film 96 (groove is formed on the surface which is uneven) made of a wiring material such as metal copper formed on the above barrier metal film 95 to fill the groove.

The object to be polished including no buried material is a substrate made of polysilicon or bare silicon.

Examples

Example 1

1. manufacture of polishing pad

1-1. production of surface treated β-cyclodextrin

100 parts by weight of β-cyclodextrin (manufactured by Yokohama International Bio Research Laboratory Co., Ltd., trade name of Dexy Pearl β-100, average particle diameter of 20 μm) as water-soluble particles was fed to a mixer (Super Mixer SMZ-3SP of Kawata Co., Ltd.), 0.5 part by weight of γ-aminopropyltriethoxysilane (manufactured by Nippon Unica Co., Ltd., trade name of A-1100) was sprayed on the water-soluble particles for 5 minutes under agitation at 400 rpm, and the coated water-soluble particles were further stirred at 400 rpm for 2 minutes. Thereafter, the extracted particles were dried by heating in a vacuum drier set at 130° C until the water content became 5,000 ppm or less to obtain surface treated β-cyclodextrin.

1-2. manufacture of polishing pad having an elliptic hole

66.5 vol% of 1,2-polybutadiene (manufactured by JSR Corporation, trade name of JSR RB830) and 28.5 vol% of polystyrene (manufactured by PS Japan Co., Ltd., trade name of HF-55) both of which would be crosslinked to become a matrix material and 5 vol% of the above surface treated β-cyclodextrin produced above as the water-soluble substance were kneaded together by an extruder heated at 160°C. Thereafter, Percumyl D40 (trade name, manufactured by NOF Corporation, containing 40 % by mass of dicumyl peroxide) was added in an amount of 0.4 part by mass (equivalent to 0.16 part by mass in terms of pure dicumyl peroxide) based on 100 parts by mass of the total of 1,2-polybutadiene and polystyrene and further kneaded with the above kneaded product to carry out a crosslinking reaction at 160°C in a press metal mold for 7 minutes so as to obtain a disk-like molded product having a diameter of 790 mm and a thickness of 3.2 mm. An elliptic hole (aspect ratio of 2.64) having a long diameter of 58 mm and a short diameter of 22 mm was formed at a position 195 mm away from the center of the pre-polishing substrate as the center thereof by an end mill of Kato Machinery Co., Ltd. in such a manner that the long diameter direction became the diameter direction of the polishing substrate to manufacture a polishing substrate having an elliptic hole.

1-3. Preparation of light-transmitting member composition

98 vol% of 1,2-polybutadiene (trade name of JSR RB830) which would be crosslinked to become a light-transmitting member and 2 vol% of the surface treated β-cyclodextrin produced in the above paragraph 1-1 as the water-soluble substance were kneaded together by an extruder heated at 160°C. Thereafter, Percumyl D40 was added in an amount of 0.4 part by mass (equivalent to 0.16 part by mass in terms of pure dicumyl peroxide) based on 100 parts by mass of 1,2-polybuatdiene and further kneaded with the above kneaded product to produce a light-transmitting member composition.

1-4. manufacture of polishing pad

Thereafter, the above manufactured polishing substrate was set in a press metal mold again, the above light-transmitting member composition was filled into the formed elliptic hole to be crosslinked at 180° C for 8 minutes to be molded into a disk-like molded product having a diameter of 790 mm and a thickness of 3.2 mm. This molded product was set in the insertion port of a wide belt sander (of Meinan Machinery Works, Inc.), and the roller was turned at 500 rpm to grind the front surface and the rear surface of the molded product by 0.08 mm (total amount of grinding of 0.32 mm) for each grit size with sandpapers having grit sizes of 120, 150, 220 and 320 (of Novatec Co., Ltd.) by moving it at 0.1 m/sec. Thereafter, only the rear surface was ground with a sandpaper having a grit size of 600 (of Novatec Co., Ltd.)

at the same roller revolution and molded product moving speed as above to remove 0.06 mm in total. Further, concentric grooves having a width of 0.5 mm, a pitch of 2 mm and a depth of 1 mm (having a rectangular sectional form) were formed on the polishing side in portions 20 mm away from the center of the polishing surface of the pad by a groove processing machine manufactured by Kato Machinery Co., Ltd. to manufacture a polishing pad.

The thickness of the obtained pad was 2.5 mm. When the arithmetic surface roughness of the rear surface of the light-transmitting member was measured with the 1LM21P of Laser Tech Co., Ltd., it was 2.2 $\mu$m and the arithmetic surface roughness of the inner wall of each of the grooves was 6.2 $\mu$m. When part of the light-transmitting member of a polishing pad manufactured in the same manner as described above was set in a quartz cell together with water and the transmittance of the light-transmitting member at a wavelength of 650 nm was measured with a UV absorptiometer (manufactured by Hitachi Ltd., type of U-2010), the average integrated transmittance of 5 measurement data was 25 %.

2. test on polishing efficiency

2-1. polishing test on wafer having a pattern

The #422 adhesive double-coated tape of 3M Limited was laminated on the rear surface of the above manufactured polishing pad and set in the Applied Reflexion chemical mechanical polishing machine of Applied Material Co., Ltd. to carry out the chemical mechanical polishing of a 12-inch wafer having a pattern (trade name of SEMATECH-754) as an object to be polished under the following conditions. Revolution of platen: 120 rpm

Revolution of polishing head: 36 rpm

Polishing pressure:

Pressure of retainer ring: 7.5 psi
Pressure of zone 1: 6.0 psi
Pressure of zone 2: 3.0 psi
Pressure of zone 3: 3.5 psi
Aqueous dispersion for chemical mechanical polishing: a mixture of CMS7401 and CMS7452 (trade names, manufactured by JSR Corporation) and water in a weight ratio of 1:1:2)
Supply rate of aqueous dispersion for chemical mechanical polishing: 300 ml/min

In the above polishing, end-point detection was carried out without a problem. When the number of scratches on the polished surface of the object after polishing was measured with the Surf Scan SP1 of KLA Ten Call Co., Ltd., it was "0" on the entire surface of the wafer.

2-2. test on the polishing of wafer having a copper film and no pattern

A 12-inch diameter wafer having a copper film and no pattern was polished as an object to be polished with a polishing pad manufactured in the same manner as in "1. manufacture of chemical mechanical polishing pad" for 1 minutes to carry out chemical mechanical polishing in the same manner as in "2-1. polishing test on wafer having a pattern".
The thickness of the copper film before and after polishing was measured at 33 points equally away from one another excluding 5 mm areas from the both ends in the diameter direction of the object, and the polishing rate and the in-plane uniformity were calculated from the measurement results based on the following equations.

**Amount of polishing = thickness of copper film before polishing - thickness of copper film after polishing**

**Polishing rate = average value of film thickness ÷ polishing time**

**In-plane uniformity = (standard deviation of amount of polishing ÷ average value of amount of polishing) x 100 (%)**

As a result, the polishing rate was 8,550 Å/min and the in-plane uniformity was 3.0%. When the value of in-plane uniformity is 5 % or less, it can be said that the in-plane uniformity is satisfactory.

Example 2

manufacture of polishing pad not being within the scope of the invention

64 vol% of 1,2-polybutadiene (manufactured by JSR Corporation, trade name of JSR RB830) and 16 vol% of a styrene-butadiene elastomer (manufactured by JSR Corporation, trade name of JSR TR2827) both of which would be crosslinked to become a matrix material and 20 vol% of the surface treated β-cyclodextrin produced in "1-1." of Example 1 as a water-soluble substance were kneaded together by an extruder heated at 160°C. Thereafter, Percumyl D40 (trade name, manufactured by NOF Corporation, containing 40 % by mass of dicumyl peroxide) was added in an amount of 0.4 part by mass (equivalent to 0.16 part by mass in terms of pure dicumyl peroxide) based on 100 parts by mass of the total of 1,2-polybutadiene and styrene-butadiene elastomer and further kneaded with the above kneaded product to carry out a crosslinking reaction at 160°C in a press metal mold for 7 minutes to obtain a disk-like molded product having a diameter of 790 mm and a thickness of 3.2 mm. An elliptic hole (aspect ratio of 1.04) having a long diameter of 50 mm and a short diameter of 48 mm was formed at a position 195 mm away from the center of the pre-polishing substrate as the center thereof by an end mill of Kato Machinery Co., Ltd. in such a manner that the long diameter direction became the diameter direction of the polishing substrate to manufacture a polishing substrate having an elliptic hole.

A polishing pad was manufactured in the same manner as in Example 1 except that the above produced polishing substrate was used as the polishing substrate having an elliptic hole.

Test on polishing efficiency

A polishing test was made in the same as in "2, test on polishing efficiency" of Example 1 except that the above produced polishing pad was used. The results are shown in Table 1.

Example 3

Manufacture of polishing pad not being within the scope of the invention

80 vol% of 1,2-polybutadiene (manufactured by JSR Corporation, trade name of JSR RB830) which would be crosslinked to become a matrix material and 20 vol% of the surface treated β-cyclodextrin produced in "1-1." of Example 1 as a water-soluble substance were kneaded together by an extruder heated at 160°C. Thereafter, Percumyl D40 was added in an amount of 0.8,part by mass (equivalent to 0.32 part by mass in terms of pure dicumyl peroxide) based on 100 parts by mass of 1,2-polybutadiene and further kneaded with the above kneaded product to carry out a crosslinking reaction at 160°C in a press metal mold for 7 minutes to obtain a disk-like molded product having a diameter of 790 mm and a thickness of 3.2 mm. An elliptic hole (aspect ratio of 10) having a long diameter of 70 mm and a short diameter of 7 mm was formed at a position 195 mm away from the center of the pre-polishing substrate as the center thereof by an end mill of Kato Machinery Co., Ltd. in such a manner that the long diameter direction became the diameter direction of the polishing substrate to manufacture a polishing substrate having an elliptic hole.

A polishing pad was manufactured in the same manner as in Example 1 except that the above produced polishing substrate was used as the polishing substrate having an elliptic hole.

Test on polishing efficiency

A polishing test was made in the same as in "2, test on polishing efficiency" of Example 1 except that the above produced polishing pad was used. The results are shown in Table 1.

Example 4

Manufacture of polishing pad not being within the scope of the invention

(1) manufacture of light-transmitting member

100 parts by weight of a prepolymer (manufactured by Uni Royal Chemical Co., Ltd., trade name of Vibrasene B670) was fed to a vessel and stirred at 80° C, and 3 parts by weight of the surface treated β-cyclodextrin produced in "1-1." of Example 1 and further 10.8 parts by weight of trimethylolpropane were added and stirred for 3 minutes. The above mixture was injected into a metal mold having a rectangular cavity measuring 180 mm x 180 mm x 3 mm and maintained at 110°C for 30 minutes to carry out a reaction, and the obtained molded product was removed from the mold. This molded product was punched by an elliptic puncher to obtain a light-transmitting member (aspect ratio of 20) having a long diameter of 120 mm, a short diameter of 6 mm and a thickness of 3 mm.

(2) preparation of polishing substrate composition

58 parts by weight of 4,4'-diphenylmethane diisocyanate (manufactured by Sumika Bayer Urethane Co., Ltd., trade name of Sumijule 44S) was fed into a reactor and stirred at 60°C, and 5.1 parts by weight of polytetramethylene glycol having a number average molecular weight of 650 and two hydroxyl groups at both terminals of the molecule (manufactured by Mitsubishi Chemical Corporation, trade name of PTMG650) and 17.3 parts by weight of polytetramethylene glycol having a number average molecular weight of 250 (manufactured by Mitsubishi Chemical Corporation, trade name of PTMG250) were added and maintained at 90°C for 2 hours under agitation to carry out a reaction and then cooled to obtain an isocyanate-terminated prepolymer. This isocyanate-terminated prepolymer contained 21 wt% of unreacted 4,4'-diphenylmethane diisocyanate and the remaining 79 wt% was a mixture of an isocyanate both-terminated prepolymer.

80.4 parts by weight of the obtained isocyanate-terminated prepolymer was placed in a stirring vessel and maintained at 90°C and stirred at 200 rpm, and 14.5 parts by weight of the above obtained water-soluble particles surface treated with a silane coupling agent was added, mixed, dispersed into the prepolymer for 1 hour and defoamed under reduced pressure to obtain an isocyanate-terminated prepolymer containing the water-soluble particles dispersed therein.

12.6 parts by weight of 1,4-bis(β-hydroxyethoxy)benzene having two hydroxyl groups at a terminal (manufactured by Mitsui Chemical Fine Co., Ltd., trade name of BHEB) was heated at 120° C in a stirring vessel for 2 hours to be molten, and 7 parts by weight of trimethylolpropane having three hydroxyl groups (manufactured by BASF Japan Co., Ltd., trade name of TMP) was added under agitation and mixed for 10 minutes to be dissolved in the above substance so as to obtain a mixture of chain extenders.

94.9 parts by weight of the above obtained isocyanate-terminated prepolymer containing water-soluble particles dispersed therein was heated at 90°C and stirred in an agitator mixer, and 19.6 parts by weight of the above obtained mixture of chain extenders heated at 120° C was added and mixed for 1 minute to obtain a polishing substrate composition.

(3) manufacture of polishing pad

The light-transmitting member obtained in (2) above was placed in a metal mold having a disk-like cavity having a diameter of 600 mm and a thickness of 3 mm at a position 100 mm away from the center of the disk as the center thereof in such a manner that the long diameter direction of the ellipse became the diameter direction of the disk. Thereafter, the polishing substrate composition produced in (3) above was injected to fill the remaining cavity in the mold and maintained at 110°C for 30 minutes to carry out a polyurethanation reaction, and the obtained molded product was removed from the mold. Further, the molded product was post-cured in a gear oven set at 110°C for 16 hours to obtain a polyurethane sheet having a diameter of 600 mm and a thickness of 3 mm and an elliptic window and containing water-soluble particles dispersed therein.

Thereafter, grinding with sandpapers and the formation of concentric grooves were carried out in the same manner as in "1-4. manufacture of polishing pad" of Example 1 to manufacture a polishing pad. The obtained pad had a thickness of 2.3 mm.

Test on polishing efficiency

A polishing test was made in the same manner as in "2. test on polishing efficiency" of Example 1 except that the above produced polishing pad was used. The results are shown in Table 1.

Example 5

A polishing pad was manufactured in the same manner as in "1-4, manufacture of polishing pad" of Example 1 except that a metal mold having a projection with the same planar shape and size as those of the elliptic hole of the polishing substrate and a height of 0. 78 mm at a position corresponding to the elliptic hole of the polishing pad was used. The rear surface of the light-transmitting area of this polishing pad was depressed by 0.7 mm from the rear surface of the polishing substrate.

A polishing test was carried out in the same manner as in "2. test on polishing efficiency" of Example 1 except that this polishing pad was used. The results are shown in Table 1.

Comparative Example 1

Manufacture of polishing pad

A polishing substrate having an elliptic hole was manufactured in the same manner as in "1-2. manufacture of polishing substrate having an elliptic hole" of Example 1.

Separately, a light-transmitting member composition produced in the same manner as in "1-3. preparation of light-transmitting member composition" of Example 1 was heated at 180° C for 10 minutes to be molded, and a hole having the same shape as the above elliptic hole but smaller than the hole was cut out to produce a light-transmitting portion. When the transmittance of the light-transmitting portion was measured in the same manner as in Example 1, the average integrated transmittance of five measurement data was 25 %.

After the #422 adhesive both-coated tape of 3M Limited was laminated on the entire rear surface of the above polishing substrate, the above produced light-transmitting portion was inserted into the hole of the polishing substrate to manufacture a polishing pad.

Test on polishing efficiency

A polishing test was made in the same manner as in "2. test on polishing efficiency" of Example 1 except that the above produced polishing pad was used. The results are shown in Table 1.

**Table 1**

|  | Polishing test on water having a pattern | | polishing test on wafer having a copper film and no pattern | |
| --- | --- | --- | --- | --- |
|  | End-point detection | number of scratches (per wafer) | polishing rate (A/min) | in-plane uniformity (%) |
| Example 1 | Possible | 0 | 8550 | 3.0 |
| Example 2 | Possible | 0 | 8100 | 2.8 |
| Example 3 | Possible | 10 | 8500 | 3.0 |
| Example 4 | Possible | 20 | 7100 | 1.8 |
| Example 5 | Possible | 0 | 8550 | 3.0 |
| Comparative Example 1 | Possible | 400 | 8400 | 2.5 |

There is provided a chemical mechanical polishing pad containing a polishing substrate having a polishing surface and a light-transmitting member fused to the polishing substrate. The sectional form of the light-transmitting member when it is cut with a plane parallel to the polishing surface is elliptic with a value obtained by dividing its long diameter by its short diameter of 1.5 to 5.

The pad is capable of transmitting end-point detection light without reducing its polishing efficiency in polishing a semiconductor wafer.

**Claims**

1. A chemical mechanical polishing pad comprising a polishing substrate having a polishing surface and a light-transmitting member fused to the polishing substrate, the sectional form of the light-transmitting member when it is cut with a plane parallel to the polishing surface being elliptic with a value obtained by dividing its long diameter by its short diameter of 1.5 to 5.

2. The chemical mechanical polishing pad according to claim 1, wherein the light-transmitting member comprises a water-insoluble material and water-soluble particles dispersed in the water-insoluble material.

3. The chemical mechanical polishing pad according to claim 2, wherein at least part of the water-insoluble material is a crosslinked polymer.

4. The chemical mechanical polishing pad according to claim 3, wherein the crosslinked polymer is 1,2-polybutadiene.

5. A process for manufacturing the chemical mechanical polishing pad of claim 1, comprising fusing the polishing substrate to the light-transmitting member in a metal mold for insert molding.

6. A method for the chemical mechanical polishing of a semiconductor wafer with the chemical mechanical polishing pad of claim 1, comprising detecting the end point of chemical mechanical polishing with an optical end-point detector through the light-transmitting member of the chemical mechanical polishing pad of claim 1.

**Patentansprüche**

1. Chemisch mechanisches Polierkissen, welches ein Poliersubstrat mit einer Polieroberfläche und ein Licht übertragendes Element, das auf die Polieroberfläche geschmolzen ist, umfasst, wobei die Querschnittsform des Licht übertragenden Elements, wenn es in einer Ebene parallel zur Polieroberfläche geschnitten wird, mit einem Wert elliptisch ist, der durch Dividieren ihres längeren Durchmessers durch ihren kürzeren Durchmesser erhalten wird und 1,5 bis 5 beträgt.

2. Das chemisch mechanische Polierkissen nach Anspruch 1, wobei das Licht übertragende Element ein in Wasser unlösliches Material und in Wasser lösliche Teilchen umfasst, die in dem in Wasser unlöslichen Material dispergiert sind.

3. Das chemisch mechanische Polierkissen nach Anspruch 2, wobei mindestens ein Teil des in Wasser unlöslichen Materials ein vernetztes Polymer ist.

4. Das chemisch mechanische Polierkissen nach Anspruch 3, wobei das vernetzte Polymer 1,2-Polybutadien ist.

5. Verfahren zur Herstellung des chemisch mechanischen Polierkissens nach Anspruch 1, welches das Aufschmelzen des Polierträgers auf das Licht übertragende Element in einer Metallform für die Einsetzabformung umfasst.

6. Verfahren zum chemisch mechanischen Polieren einer Halbleiterscheibe mit dem chemisch mechanischen Polierkissen nach Anspruch 1, welches das Erfassen des Endpunktes des chemisch mechanischen Polierens mit einem optischen Endpunktdetektor durch das Licht übertragende Element des chemisch mechanischen Polierkissens aus Anspruch 1 umfasst.

**Revendications**

1. Tampon de polissage chimique et mécanique comprenant un substrat de polissage ayant une surface de polissage et un élément de transmission de lumière fixé par fusion au substrat de polissage, la forme en coupe de l'élément de transmission de lumière, lorsqu'il est coupé avec un plan parallèle à la surface de polissage, étant elliptique, avec une valeur obtenue en divisant son diamètre long par son diamètre court de 1,5 à 5.

2. Tampon de polissage chimique et mécanique selon la revendication 1, dans lequel l'élément de transmission de lumière comprend un matériau insoluble dans l'eau et des particules solubles dans l'eau dispersées dans le matériau insoluble dans l'eau.

3. Tampon de polissage chimique et mécanique selon la revendication 2, dans lequel au moins une partie du matériau insoluble dans l'eau est un polymère réticulé.

4. Tampon de polissage chimique et mécanique selon la revendication 3, dans lequel le polymère réticulé est du 1,2-polybutadiène.

5. Procédé de fabrication du tampon de polissage chimique et mécanique selon la revendication 1, comprenant le fixage par fusion du substrat de polissage à l'élément de transmission de lumière dans un moule métallique en vue d'un moulage avec un insert.

6. Procédé de polissage chimique et mécanique d'une tranche de semiconducteur avec le tampon de polissage chimique et mécanique selon la revendication 1, comprenant la détection du point final du polissage chimique et mécanique avec un détecteur de point final optique à travers l'élément de transmission de lumière du tampon de polissage chimique et mécanique selon la revendication 1.

Fig. 1

1 2

Fig. 2

1 2

Fig. 3

12

13

Fig. 4

12

13

Fig. 5

13

1

12

Fig. 6

Fig. 7

Fig. 8

Fig. 9

Fig. 10

EP 1 591 201 B1

Fig. 11

9

96

95

94

93

92

91